# EUROPEAN PATENT APPLICATION

(11) **EP 1 143 507 A1**
(43) Date of publication of application: **10.10.2001**
(21) Application number: 99959697.6
(22) Date of filing: 08.12.1999
(51) Int. Cl.: H01L 21/82, H01L 27/04

(54) **INTEGRATED CIRCUIT**

(30) Priority: 10.12.1998 JP 35193698
(71) Applicant: NEC Corporation, Minato-ku, Tokyo 108-0014 (JP)
(72) Inventor: WABUKA, Hiroshi, Minato-ku, Tokyo 108-0014 (JP)
(74) Representative: Splanemann Reitzner Baronetzky Westendorp Patentanwälte
(86) International application number: JP9906872
(87) International publication number: WO0035004

(57) **Abstract**

The present invention provides a semiconductor integrated circuit including a plurality of different primitive cells constituting a functional block, characterized in that the semiconductor integrated circuit includes a bypass capacitor electrically connected between a wire electrically connected to a power source and a grounded wire in a specific primitive cell into which a periodically varying signal is input, and the bypass capacitor is located adjacent to a gate circuit to which the periodically varying signal is input, among a plurality of gate circuits constituting the primitive cells. In accordance with the semiconductor integrated circuit, an impedance of the bypass capacitor arranged in a primitive cell is reduced in a high frequency band, and resultingly, a total of a resistance of a wire electrically connected to a power source, in IC chip, an inductance in IC chip, and an inductance of IC package is greater than an impedance of the bypass capacitor in a high frequency band. This ensures reduction in leakage of a high frequency current generated in IC, to outside of IC. As a result, it is possible to suppress EMI noises generated in IC.

## Description

### FIELD OF THE INVENTION

The invention relates to a cell-based semiconductor integrated circuit (hereinafter, referred to simply as "IC") including functional blocks each of which is comprised of primitive cells (basic cells) such as a flip-flop circuit, a NAND circuit, a NOR circuit or an inverter circuit, and more particularly to a semiconductor integrated circuit which is capable of suppressing electromagnetic interference (hereinafter, referred to simply as "EMI") noises which leaks around IC when it is in operation.

### BACKGROUND OF THE INVENTION

When IC was to be mounted on a printed circuit board, a bypass capacitor has been conventionally additionally externally connected to IC in order to suppress EMI noises which will be emitted from IC. However, the additionally externally connected bypass capacitor cannot suppress EMI noises in high frequency bands because of parasitic inductance of the capacitor and/or inductance of an IC package.

Hence, a bypass capacitor is incorporated in IC in order to suppress EMI noises.

For instance, Japanese Unexamined Patent Publication No. 10-150148 has suggested a capacitor comprised of two-layered polysilicon layers, and positioned in the vicinity of a functional block in IC or in a wiring area in a functional block.

Japanese Unexamined Patent Publication No. 10-135336 has suggested a semiconductor integrated circuit including MOS capacitors associated with macro-cells. Resistances both in the MOS capacitors and electric power wires suppress EMI noises which would be generated in the semiconductor integrated circuit.

Japanese Unexamined Patent Publication No. 5-55380 has suggested a semiconductor integrated circuit including a capacitor electrode entirely covering a chip therewith, and a bypass capacitor electrically connected across a power source and a ground.

Japanese Unexamined Patent Publication No. 6-132481 has suggested a semiconductor integrated circuit including a de-coupling capacitor located in the vicinity of a switching device below a wiring channel.

Japanese Patent No. 2682397 (Japanese Unexamined Patent Publication No. 7-106521) has suggested a semiconductor integrated circuit including a capacitor cell formed in a wiring area in accordance with a cell-base design process, and a bypass capacitor formed in LSI between a wire electrically connected to a power source and a ground (GND) wiring without an increase of a chip size. This ensures that LSI can have an enhanced resistance to noises.

Japanese Unexamined Patent Publication No. 5-315618 has suggested a semiconductor device in which a second gate electrode is electrically connected to a positive voltage of a power source supplying power to a gate driving circuit. A deviation current generated in switching is absorbed into or bypassed through the second gate electrode. As a result, it is possible to prevent a deviation current from running through a first gate electrode, ensuring that voltage fluctuation is not prevented in the first gate electrode.

Japanese Unexamined Patent Publication No. 10-125861 has suggested a semiconductor integrated circuit in which a bypass capacitor is formed partially on a region in which a source resistance is formed, on a semiconductor chip. Hence, it is possible to reduce an area the bypass capacitor occupies by an area in which the bypass capacitor overlaps the source resistance. As a result, a semiconductor chip size can be reduced, even if a bypass capacitor is externally added to the semiconductor integrated circuit.

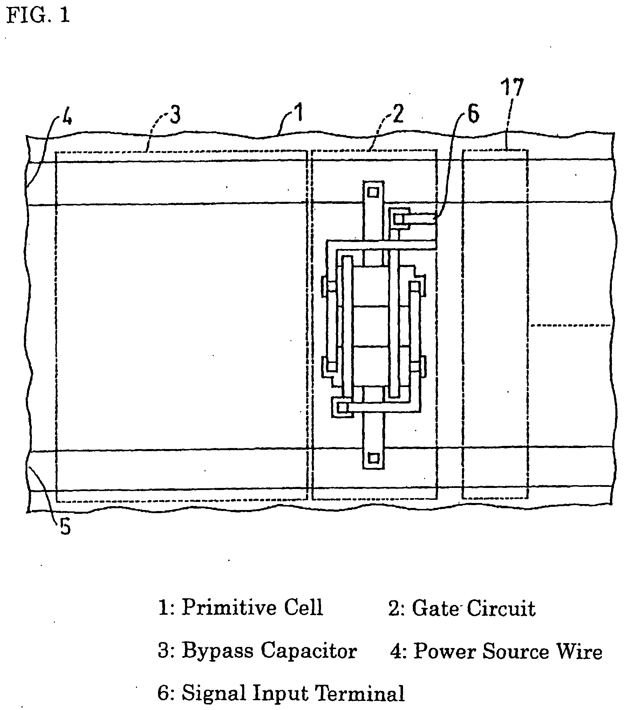

FIG. 1 illustrates another conventional semiconductor integrated circuit. The illustrated conventional IC is designed to include a gate circuit 100 electrically connected across a wire 101 connected to a power source, and a grounded wire 102.

In the conventional IC having a bypass capacitor externally added thereto, as suggested in the above-mentioned Japanese Unexamined Patent Publication No. 10-150148, a bypass capacitor is arranged for each of macro-cells. As a result, the conventional IC is accompanied with a problem that EMI noises cannot sufficiently suppressed in a high frequency band due to impedance of a wire electrically connected to a power source and across the bypass capacitor and a gate circuit positioned in a functional block or macro-cell which generates noises.

The MOSFET capacitor of IC suggested in Japanese Unexamined Patent Publication No. 10-135336 is accompanied with problems that the capacitor would have a high impedance when the capacitor has a high capacity, and that when the capacitor has a large-sized gate electrode, a semiconductor substrate or a well region acting as an opposing electrode would have a high equivalent series resistance, resulting in an increase in an impedance of the capacitor in a high frequency band.

The IC suggested in Japanese Unexamined Patent Publication No. 5-55380 is accompanied with a problem that since the capacitor electrode formed entirely covering a chip therewith, the gate electrode unavoidably has a large size, and an equivalent series resistance is high, resulting in that the capacitor has a high impedance in a high frequency band.

The IC suggested in Japanese Unexamined Patent Publication No. 6-132481 is accompanied with a problem that since it is impossible to shorten a wiring length between the switching device and a power source and between the switching device and a ground, an impedance cannot be reduced.

The IC suggested in Japanese Patent No. 2682397 (Japanese Unexamined Patent Publication No. 7-106521) is accompanied with a problem that since the bypass capacitor has to be fabricated in LSI, the process of fabricating the IC is unavoidably complicated.

The semiconductor device suggested in Japanese Unexamined Patent Publication No. 5-315618 is accompanied with a problem that since there have to be fabricated two gate electrodes, that is, the first and second gate electrodes, each of the gate electrodes is unavoidably large in size, and an equivalent series resistance is also unavoidably high, resulting in that the capacitor has a high impedance in a high frequency band.

The IC suggested in Japanese Unexamined Patent Publication No. 10-125861 is accompanied with a problem that since the bypass capacitor overlaps the source resistance area only in a small area, it would be impossible to sufficiently suppress EMI noises unless an additional bypass capacitor is externally added to the IC.

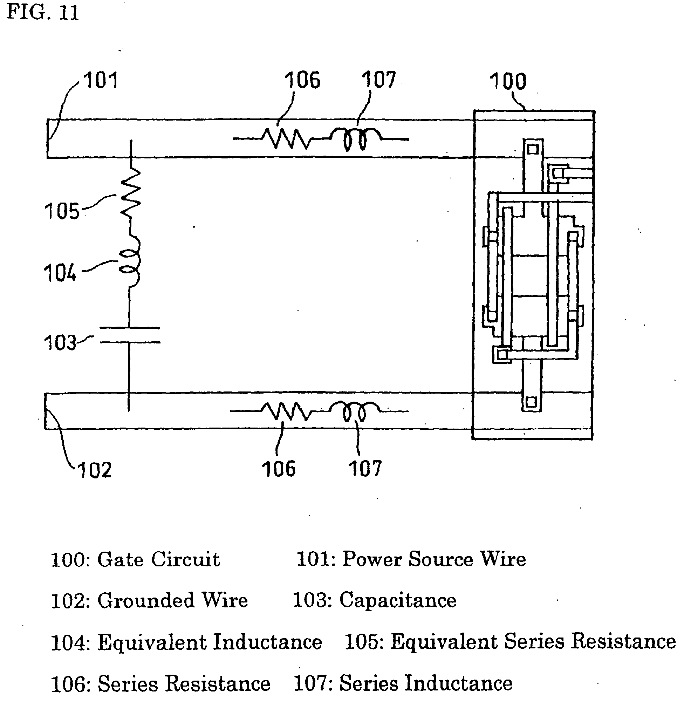

In the conventional IC illustrated in FIG. 11, each of the wire 101 electrically connected to a power source and the grounded wire 102 has a series resistance 106 and a series inductance 107. In a high frequency band, an impedance of the wires 101 and 102 at a side of a power source becomes high for the gate circuit 100 because of the series resistance 106 and the series inductance 107. As a result, an impedance of the wire 101 is not ignorable relative to an impedance of the capacitor. Hence, if a bypass capacitor is arranged in each of a functional block or macro-cell, there will be caused a problem that EMI noises cannot be sufficiently suppressed in a high frequency band because of an impedance of the wire 101 between the bypass capacitor and a gate circuit arranged in a functional block or macro-cell from which noises are generated.

In addition, since a functional block or macro-cell includes a plurality of the gate circuits 100 which generates noises, it would be impossible to arrange a bypass capacitor such that the bypass capacitor is located at a minimum distance from the gate circuits 100, namely, an impedance of the wire 101 is minimized.

If a capacitor is formed in the IC, there is formed an equivalent circuit comprised of a capacitance 103, an equivalent inductance 104 connected in series to the capacitance 103, and an equivalent resistance 105 connected in series to the inductance 104. In the equivalent circuit, if the capacitor had a high capacitance, that is, if a gate electrode were large in size, the capacitor would have a high impedance, which is not ignorable in a high frequency band. As a result, it would be impossible to sufficiently suppress EMI noises.

In view of the above-mentioned problems, it is an object of the present invention to provide a semiconductor integrated circuit which is capable of reducing an impedance in a high frequency band to thereby sufficiently suppress EMI noises.

### DISCLOSURE OF THE INVENTION

To accomplish the object, the present invention provides a semiconductor integrated circuit including a plurality of different primitive cells constituting a functional block, characterized in that the semiconductor integrated circuit includes a bypass capacitor electrically connected between a wire electrically connected to a power source and a grounded wire in a specific primitive cell into which a periodically varying signal is input, and the bypass capacitor is located adjacent to a gate circuit to which the periodically varying signal is input, among a plurality of gate circuits constituting the primitive cells.

For instance, the periodically varying signal is comprised of a clock signal.

The bypass capacitor may be designed to include any one of a first capacitor which has an electrode comprised of a gate electrode of a field effect transistor, and the other electrode comprised of a semiconductor substrate located below the gate electrode with an interlayer insulating film being sandwiched therebetween, a second capacitor which has an electrode comprised of a gate electrode of a field effect transistor, and the other electrode comprised of a metal wiring layer located above the gate electrode with an interlayer insulating film being sandwiched therebetween, a third capacitor which has an electrode comprised of a polysilicon layer in a wiring area, and the other electrode comprised of a semiconductor substrate or a well region located below the polysilicon layer with an interlayer insulating film being sandwiched therebetween, and a fourth capacitor which has an electrode comprised in a polysilicon layer of a wiring area, and the other electrode comprised of a metal wiring layer located above the polysilicon layer with an interlayer insulating film being sandwiched therebetween.

For instance, the second capacitor may be designed to include a capacitor comprised of a p-type MOS transistor and a capacitor comprised of a n-type MOS transistor, wherein a gate electrode of the capacitor comprised of a p-type MOS transistor is electrically connected to the wire electrically connected to a power source, and a gate electrode of the capacitor comprised of a n-type MOS transistor is electrically connected to the grounded wire.

It is preferable that the gate electrode and the polysilicon layer are substantially square in shape.

In the semiconductor integrated circuit in accordance with the present invention, a bypass capacitor is located adjacent to a gate circuit into which a periodically varying signal which is a main source of EMI noises, for instance, a clock signal is input, in a primitive cell. This ensures that a wire length between a gate circuit and the bypass capacitor can be minimized, and further that an inductance and a resistance of a wire can be minimized. As a result, an impedance at a side of a power source, viewing from the gate circuit, can be reduced in a high frequency band, and hence, EMI noises can be sufficiently suppressed.

### BRIEF DESCRIPTION OF THE DRAWINGS

FIG. 1 is a plan view of a semiconductor integrated circuit in accordance with the first embodiment of the present invention.
FIG. 2 is a plan view of a bypass capacitor in the semiconductor integrated circuit in accordance with the first embodiment of the present invention.
FIG. 3(a) is a cross-sectional view taken along the line A-A in FIG. 2, FIG. 3(b) is a cross-sectional view taken along the line B-B in FIG. 2, and FIG. 3(c) is a cross-sectional view taken along the line C-C in FIG. 2.
FIG. 4 is a plan view of a bypass capacitor in the semiconductor integrated circuit in accordance with the second embodiment of the present invention.
FIG. 5(a) is a cross-sectional view taken along the line D-D in FIG. 4, and FIG. 5(b) is a cross-sectional view taken along the line E-E in FIG. 4.
FIG. 6 is a plan view of a semiconductor integrated circuit in accordance with the third embodiment of the present invention.
FIG. 7 is a plan view of a bypass capacitor in the semiconductor integrated circuit in accordance with the third embodiment of the present invention.
FIG. 8(a) is a cross-sectional view taken along the line F-F in FIG. 7, FIG. 8(b) is a cross-sectional view taken along the line G-G in FIG. 7, and FIG. 8(c) is a cross-sectional view taken along the line H-H in FIG. 7.
FIG. 9 is a plan view of a bypass capacitor in the semiconductor integrated circuit in accordance with the fourth embodiment of the present invention.
FIG. 10(a) is a cross-sectional view taken along the line I-I in FIG. 9, and FIG. 10(b) is a cross-sectional view taken along the line J-J in FIG. 9.
FIG. 11 illustrates a structure of a conventional semiconductor integrated circuit.

### DESCRIPTION OF THE PREFERRED EMBODIMENTS

Preferred embodiments in accordance with the present invention will be explained hereinbelow with reference to accompanying drawings.

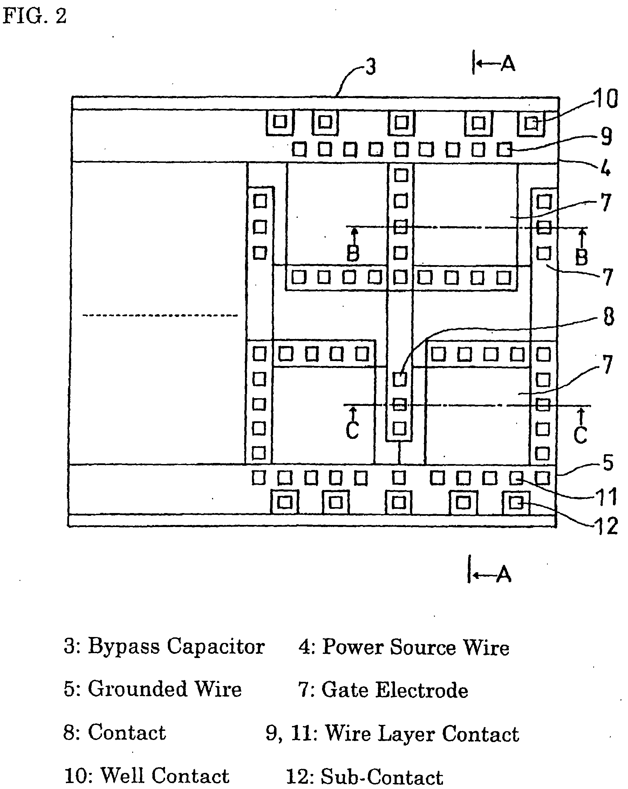

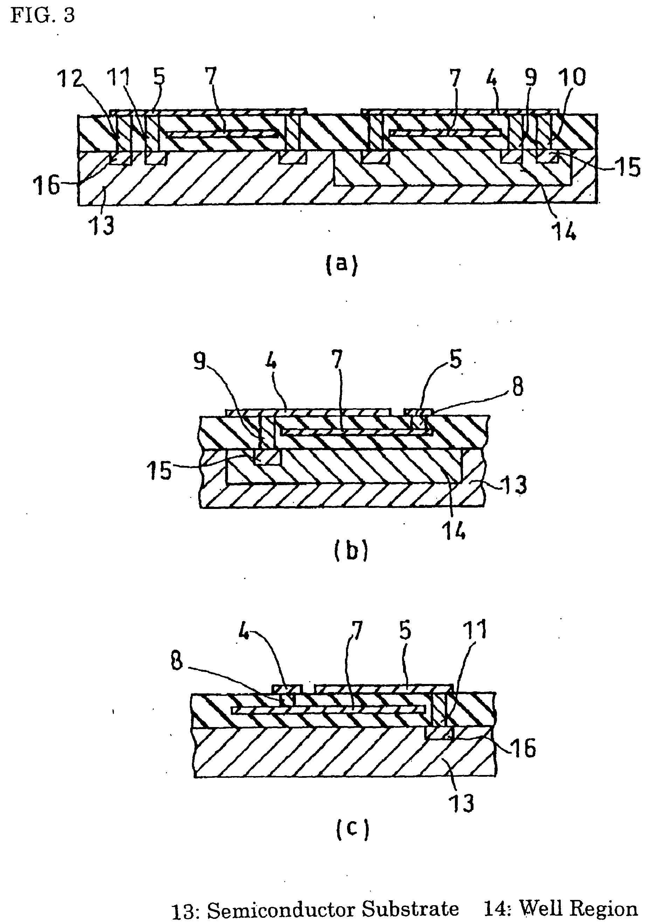

FIGs. 1 to 3 illustrate a semiconductor integrated circuit in accordance with the first embodiment of the present invention. FIG. 1 is a plan view of a semiconductor integrated circuit in accordance with the first embodiment of the present invention. FIG. 2 is a plan view of a bypass capacitor in the semiconductor integrated circuit in accordance with the first embodiment of the present invention. FIG. 3(a) is a cross-sectional view taken along the line A-A in FIG. 2, FIG. 3(b) is a cross-sectional view taken along the line B-B in FIG. 2, and FIG. 3(c) is a cross-sectional view taken along the line C-C in FIG. 2.

With reference to Fig. 1, in the semiconductor integrated circuit in accordance with the first embodiment, a primitive cell 1 is comprised of a gate circuit 2 including a signal input terminal 6 into which a clock signal as a periodic signal is directly input, a bypass capacitor 3 located adjacent to the gate circuit 2, another gate circuit 17 located at an opposite side of the bypass capacitor 3 with respect to the gate circuit 2, a wire 4 electrically connected to a power source and extending at upper ends of the gate circuit 2, the bypass capacitor 3 and another gate circuit 17, and a grounded wire 5 extending at lower ends of the gate circuit 2, the bypass capacitor 3 and another gate circuit 17.

As illustrated in FIG. 2 and FIG. 3(a), the bypass capacitor 3 is comprised of a MOS capacitor comprised of a p-type MOS field effect transistor (hereinafter, referred to simply as "p-type MOS transistor") and a metal wire layer type capacitor comprised of a n-type MOS field effect transistor (hereinafter, referred to simply as "n-type MOS transistor"). A plurality of the capacitors each comprised of a p-type MOS transistor is arranged along the power source wire 4, and a plurality of the capacitors each comprised of a n-type MOS transistor is arranged along the grounded wire 5.

As illustrated in FIGs. 3(a) and 3(b), the MOS capacitor is comprised of a capacitor including an electrode comprised of a gate electrode 7 of the p-type MOS transistor, and the other electrode comprised of a semiconductor substrate 13 located below the gate electrode 7 with an interlayer insulating film being sandwiched therebetween, and a capacitor including an electrode comprised of a polysilicon layer constituting the gate electrode 7 of the p-type MOS transistor, and the other electrode comprised of a metal wire layer located above the gate electrode 7 with an interlayer insulating film being sandwiched therebetween.

The p-type MOS transistor is electrically connected to the power source wire 4 and a p-type diffusion layer 15 through a wire layer contact 9 and a well contact 10, respectively.

The gate electrode 7 of the p-type MOS transistor, comprised of a polysilicon layer, is formed almost square in shape. The gate electrode 7 is equal in size to a couple of transistors constituting the gate circuit 2.

As illustrated in FIG. 3(b), the gate electrode 7 is electrically connected at one side thereof to the grounded wire 5 through contacts 8 formed in a line in a metal wiring layer making contact with the grounded wire 5. The p-type diffusion layer 15 adjacent to the rest three sides of the gate electrode 7 is electrically connected to the power source wire 4 through contacts 9 formed in a line.

As illustrated in FIGs. 3(a) and 3(c), the metal wire layer type capacitor is comprised of a capacitor including an electrode comprised of a gate electrode 7 of the n-type MOS transistor, and the other electrode comprised of a semiconductor substrate 13 located below the gate electrode 7 with an interlayer insulating film being sandwiched therebetween, and a capacitor including an electrode comprised of a polysilicon layer constituting the gate electrode 7 of the n-type MOS transistor, and the other electrode comprised of a metal wire layer located above the polysilicon layer with an interlayer insulating film being sandwiched therebetween.

As illustrated in FIG. 3(a), in the metal wire layer type capacitor, the grounded wire 5 is electrically connected to n-type diffusion layers 16 through a wire layer contact 11 and a sub-contact 12. The gate electrode 7 of the n-type MOS transistor is formed almost square in shape. The gate electrode 7 is equal in size to a couple of transistors constituting the gate circuit 2.

As illustrated in FIG. 3(c), the gate electrode 7 is electrically connected at one side thereof to the power source wire 4 through contacts 8 formed in a line in a metal wiring layer making contact with the power source wire 4. The n-type diffusion layer 16 (N⁺) adjacent to the rest three sides of the gate electrode 7 is electrically connected to the grounded wire 5 through wire layer contacts 11 formed in a line.

As mentioned so far, a plurality of the capacitors each including the small-sized gate electrode 7 and electrically connected in parallel to one another defines the bypass capacitor 3 which has a small impedance in a high frequency band.

An operation of the semiconductor integrated circuit in accordance with the first embodiment is explained hereinbelow.

When the gate circuit 2 in the primitive cell 1 is operated by inputting signals thereto, a series resistance and a series inductance of the power source wire 4 and the grounded wire 5 between the gate circuit 2 and the bypass capacitor 3 are minimized, since the bypass capacitor 3 is located adjacent to the gate circuit 2 in the primitive cell 1. Thus, it would be possible to prevent an increase in an impedance of the bypass capacitor 3 in a high frequency band, viewing from the gate circuit 2.

EMI noises in IC are generated as a result that a high frequency current running through the power source wire 4 and the grounded wire 5 leaks out of IC, when the gate circuit 2 in IC operates in accordance with input signals, and charge or discharge load capacitance. Hence, it is possible to prevent generation of EMI noises by preventing an increase in an impedance of the bypass capacitor 3 in a high frequency band.

When the gate circuit 2 in the primitive cell 1 is operated by inputting signals thereto, a parasitic series resistance and a series inductance of the gate electrode 7 (polysilicon layer) and the metal wire layer electrode of the capacitor can be smaller than an impedance of a capacitance in a high frequency band, since the gate electrode 7 is formed almost square in shape and is equal in size to a couple of MOS transistors. Hence, it is possible to prevent an increase in an impedance of the capacitor in a high frequency band. As a result, it is possible to suppress generation of EMI noises.

In addition, since the gate electrode 7 in the vicinity of the semiconductor substrate 113 or the well region 14 is electrically connected to the power source wire 4 and the grounded wire 5 through a plurality of the contacts 8, the gate electrode 7 has a reduced series resistance.

In the first embodiment, the bypass capacitor 3 is located adjacent to the gate circuit 2 into which a clock signal, which is a main source of EMI noises, is input, in the primitive cell 1. This ensures that a length of the power source wire between the gate circuit 2 and the bypass capacitor 3 can be minimized, and an inductance and a resistance of the power source wire can be minimized. Accordingly, the bypass capacitor 3 can reduce an impedance at a side of the power source, viewing from the gate circuit 2, in a high frequency band.

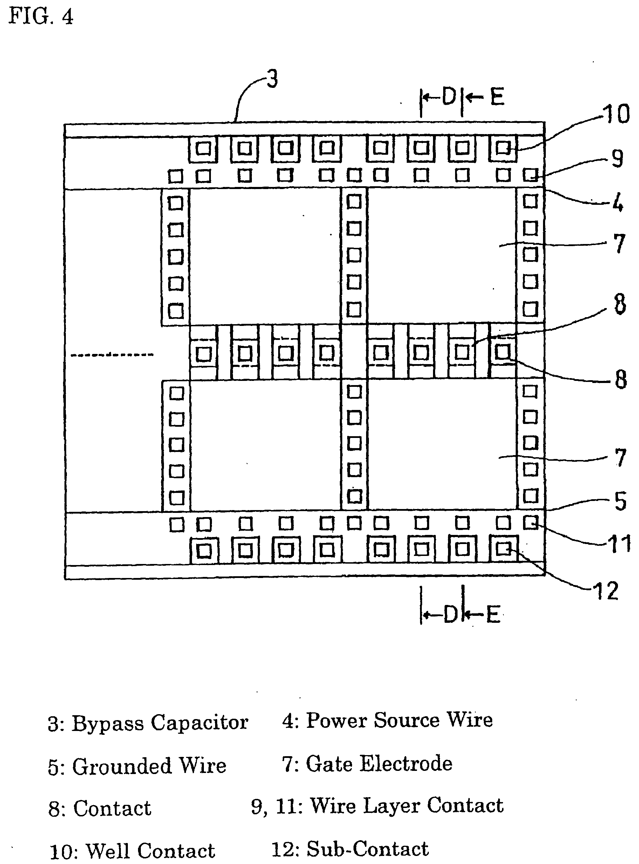

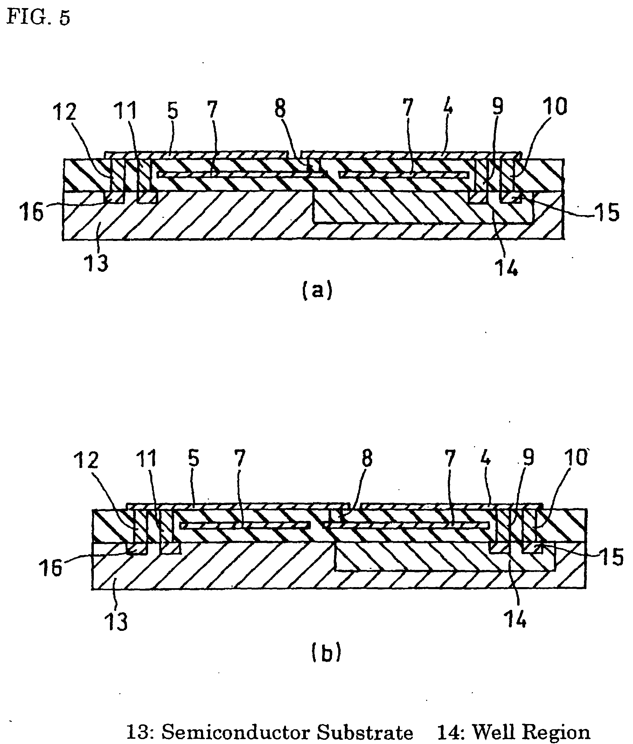

Hereinbelow is explained a semiconductor integrated circuit in accordance with the second embodiment of the present invention, with reference to FIGs. 4 and 5. Parts or elements that correspond to those of the first embodiment illustrated in FIGs. 1 to 3 have been provided with the same reference numerals, and will not be explained in detail. FIG. 4 is a plan view of a bypass capacitor in the semiconductor integrated circuit in accordance with the second embodiment of the present invention. FIG. 5(a) is a cross-sectional view taken along the line D-D in FIG. 4, and FIG. 5(b) is a cross-sectional view taken along the line E-E in FIG. 4.

The second embodiment is different from the first embodiment only in that the capacitor is different in shape from the capacitor of the first embodiment, and has the same structure as the first embodiment except a shape of the capacitor.

That is, as illustrated in FIGs. 5(a) and 5(b), the gate electrode 7 of the bypass capacitor 3 is designed to extend towards a gap formed between a capacitor comprised of the p-type MOS transistor and a capacitor comprised of the n-type MOS transistor. The gate electrode 7 located below one of the transistors is designed to have an end located below the other of the transistors.

As illustrated in FIG. 5(a), the gate electrode 7 of a capacitor comprised of the p-type MOS transistor is electrically connected at the end thereof to the power source wire 4 through the contacts 8. In contrast, as illustrated in FIG. 5(b), the gate electrode 7 of a capacitor comprised of the n-type MOS transistor is electrically connected at the end thereof to the grounded wire 5 through the contacts 8.

As mentioned above, the gate electrode 7 of the bypass capacitor 3 is designed to have an end below a gap formed between a capacitor comprised of the p-type MOS transistor and a capacitor comprised of the n-type MOS transistor. This ensures that an equivalent series resistance of the gate electrode 7 is reduced, and that an impedance of the bypass capacitor 3 in a high frequency band is reduced.

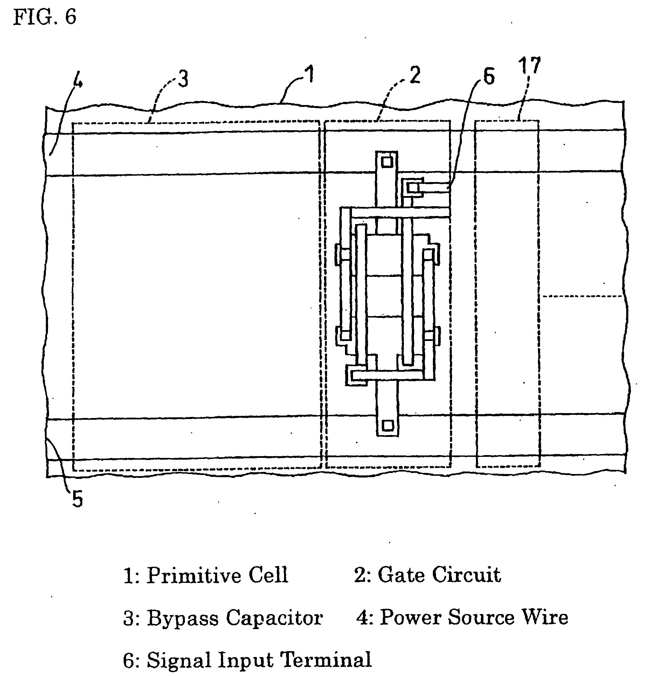

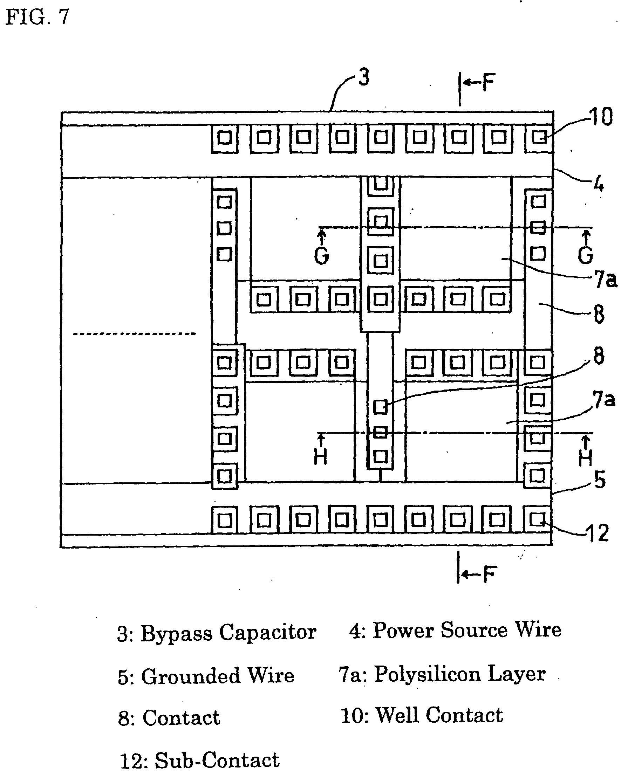

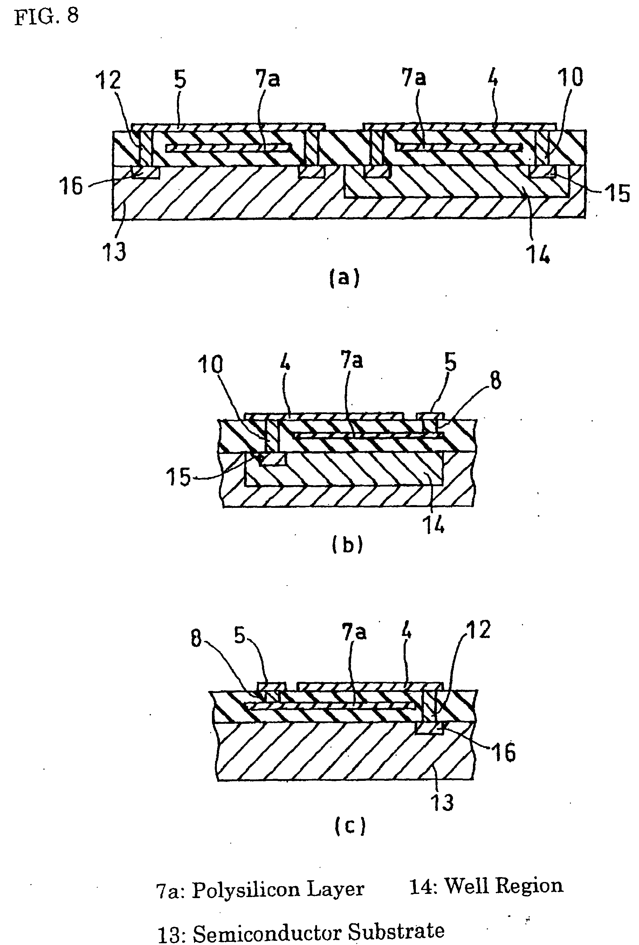

Hereinbelow is explained a semiconductor integrated circuit in accordance with the third embodiment of the present invention, with reference to FIGs. 6 to 8. Parts or elements that correspond to those of the first embodiment illustrated in FIGs. 1 to 3 have been provided with the same reference numerals, and will not be explained in detail. FIG. 6 is a plan view of a semiconductor integrated circuit in accordance with the third embodiment of the present invention. FIG. 7 is a plan view of a bypass capacitor in the semiconductor integrated circuit in accordance with the third embodiment of the present invention. FIG. 8(a) is a cross-sectional view taken along the line F-F in FIG. 7, FIG. 8(b) is a cross-sectional view taken along the line G-G in FIG. 7, and FIG. 8(c) is a cross-sectional view taken along the line H-H in FIG. 7.

The third embodiment is different from the first embodiment in that the bypass capacitor 3 is comprised of a polysilicon capacitor and a metal wire capacitor.

That is, as illustrated in FIG. 8(a), the bypass capacitor 3 is comprised of a capacitor which forms a capacitance between a polysilicon layer 7a formed in a wire area, and a semiconductor substrate 13 or a well region 14 formed below the polysilicon layer 7a with an interlayer insulating film being sandwiched therebetween, and a capacitor which forms a capacitance between a polysilicon layer 7a and a metal wire layer formed above the polysilicon layer 7a with an interlayer insulating film being sandwiched therebetween.

The third embodiment is different from the first and second embodiments in that each of the capacitors is not electrically connected to the power source wire 4 and the grounded wire 5 through wire layer contacts 9 and 11 unlike the first and second embodiments, but has the same structure as the structure of the first embodiment except that.

As illustrated in FIGs. 8(a) and 8(b), the polysilicon layer 7a in the polysilicon capacitor is electrically connected at an end thereof to the grounded wire 5 through the contact 8. The p-type diffusion layer 15 formed in the well region 14 located below the polysilicon layer 7a is electrically connected to the power source wire 4 through a well contact 10.

As illustrated in FIGs. 8(a) and 8(c), the polysilicon layer 7a in the metal wire capacitor is electrically connected at an end thereof to the grounded wire 5 through the contact 8. The n-type diffusion layer 16 formed in the semiconductor substrate 13 located below the polysilicon layer 7a is electrically connected to the power source wire 4 through a sub-contact 12.

As mentioned so far, a plurality of the capacitors each having a small capacitance and electrically connected in parallel to one another would render an impedance defined by a parasitic inductance and a resistance of the capacitor in a high frequency band smaller than an impedance defined by a capacitance of the capacitor. As a result, there can be obtained a bypass capacitor having a small impedance in a high frequency band.

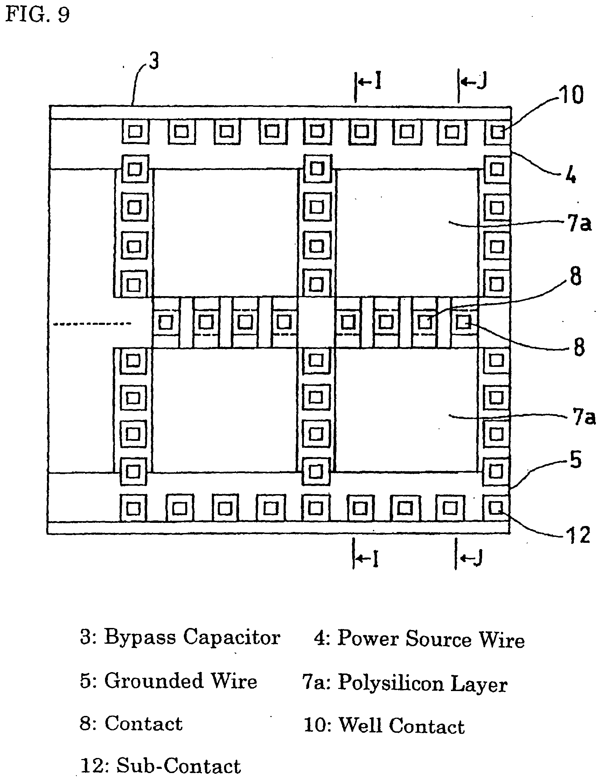

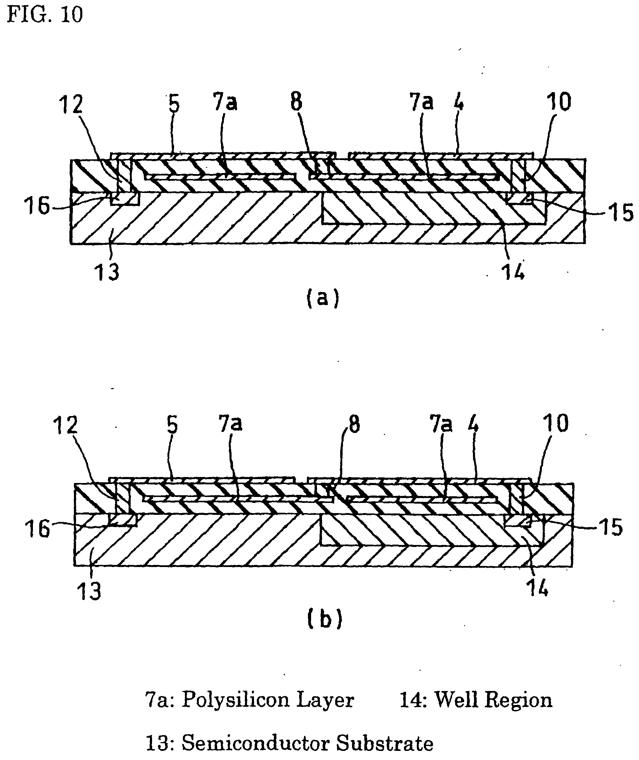

Hereinbelow is explained a semiconductor integrated circuit in accordance with the fourth embodiment of the present invention, with reference to FIGs. 9 and 10. Parts or elements that correspond to those of the third embodiment illustrated in FIGs. 6 to 8 have been provided with the same reference numerals, and will not be explained in detail. FIG. 9 is a plan view of a bypass capacitor in the semiconductor integrated circuit in accordance with the fourth embodiment of the present invention. FIG. 10(a) is a cross-sectional view taken along the line I-I in FIG. 9, and FIG. 10(b) is a cross-sectional view taken along the line J-J in FIG. 9.

Similarly to the third embodiment, the bypass capacitor 3 in the fourth embodiment is comprised of a capacitor which forms a capacitance between a polysilicon layer 7a formed in a wire area, and a semiconductor substrate 13 or a well region 14 formed below the polysilicon layer 7a with an interlayer insulating film being sandwiched therebetween, and a capacitor which forms a capacitance between a polysilicon layer 7a and a metal wire layer formed above the polysilicon layer 7a with an interlayer insulating film being sandwiched therebetween.

As illustrated in FIGs. 10(a) and 10(b), the fourth embodiment is different from the third embodiment in that the polysilicon layer 7a of the bypass capacitor 3 is designed to extend towards an area at which the capacitors face each other, and that the polysilicon layer 7a located below one of the transistors is designed to have an end located below the other of the transistors.

As illustrated in FIG. 10(a), the polysilicon layer 7a in one of the capacitors is electrically connected at the end thereof to the grounded wire 5 through the contact 8. In contrast, as illustrated in FIG. 10(b), the polysilicon layer 7a in the other of the capacitors is electrically connected at the end thereof to the power source wire 4 through the contact 4.

As mentioned so far, the polysilicon layer 7a in the bypass capacitor 3 is designed to extend towards an area in which the capacitors face each other, and further designed not to be electrically connected to the power source wire 4 and the grounded wire 5 through the wire layer contacts 9 and 11. This ensures that a plurality of the capacitors each having a small capacitance and electrically connected in parallel to one another would render an impedance defined by a parasitic inductance and a resistance of the capacitor in a high frequency band smaller than an impedance defined by a capacitance of the capacitor. As a result, it would be possible to reduce an equivalent series inductance and an equivalent series resistance.

In each of the above-mentioned embodiments, a clock signal as a periodically varying signal is input into the primitive cell. The present invention may be applied to not only a primitive cell into which a clock signal is input, but also a primitive cell into which signal is input relatively periodically.

That is, there can be obtained the same advantages as those obtained by the above-mentioned embodiments, even if a signal is relatively periodically input into the signal input terminal 6 illustrated in FIGs. 1 and 6, in place of the clock signal to be input into the signal input terminal 6.

If only the small number of primitive cells receive a clock signal through the signal input terminal 6 due to a specific structure of IC, the bypass capacitor 3 could be effectively incorporated in IC.

### INDUSTRIAL APPLICABILITY

As having been explained so far, in accordance with the semiconductor integrated circuit, an impedance of the bypass capacitor arranged in a primitive cell is reduced in a high frequency band, and resultingly, a total of a resistance of a power source wire in IC chip, an inductance in IC chip, and an inductance of IC package is greater than an impedance of the bypass capacitor in a high frequency band. This ensures reduction in leakage of a high frequency current generated in IC, to outside of IC. As a result, it is possible to suppress generation of EMI noises in IC.

In addition, since the electric charges necessary for an operation of a gate circuit, that is, a current in a high frequency band is supplied through the bypass capacitor arranged in a primitive cell, it would be possible to operate a gate circuit without being influenced by an impedance of a power source wire in IC chip, and IC package. This ensures a higher rate at which IC operates.

## Claims

1. A semiconductor integrated circuit including a plurality of different primitive cells constituting a functional block,
**characterized in that**
said semiconductor integrated circuit includes a bypass capacitor electrically connected between a wire electrically connected to a power source and a grounded wire in a specific primitive cell into which a periodically varying signal is input, and
said bypass capacitor is located adjacent to a gate circuit to which said periodically varying signal is input, among a plurality of gate circuits constituting said primitive cells.

2. The semiconductor integrated circuit as set forth in claim 1, wherein said periodically varying signal is a clock signal.

3. The semiconductor integrated circuit as set forth in claim 1 or 2, wherein said bypass capacitor includes a first capacitor which has an electrode comprised of a gate electrode of a field effect transistor, and the other electrode comprised of a semiconductor substrate located below said gate electrode with an interlayer insulating film being sandwiched therebetween.

4. The semiconductor integrated circuit as set forth in claim 1 or 2, wherein said bypass capacitor includes a second capacitor which has an electrode comprised of a gate electrode of a field effect transistor, and the other electrode comprised of a metal wiring layer located above said gate electrode with an interlayer insulating film being sandwiched therebetween.

5. The semiconductor integrated circuit as set forth in claim 4, wherein said second capacitor includes a capacitor comprised of a p-type MOS transistor and a capacitor comprised of a n-type MOS transistor, a gate electrode of said capacitor comprised of a p-type MOS transistor is electrically connected to said wire electrically connected to a power source, and a gate electrode of said capacitor comprised of a n-type MOS transistor is electrically connected to said grounded wire.

6. The semiconductor integrated circuit as set forth in claim 1 or 2, wherein said bypass capacitor includes a third capacitor which has an electrode comprised of a polysilicon layer in a wiring area, and the other electrode comprised of a semiconductor substrate or a well region located below said polysilicon layer with an interlayer insulating film being sandwiched therebetween.

7. The semiconductor integrated circuit as set forth in claim 1 or 2, wherein said bypass capacitor includes a fourth capacitor which has an electrode comprised in a polysilicon layer of a wiring area, and the other electrode comprised of a metal wiring layer located above said polysilicon layer with an interlayer insulating film being sandwiched therebetween.

8. The semiconductor integrated circuit as set forth in any one of claims 3 to 7, wherein said gate electrode and said polysilicon layer is substantially square in shape.
